(19) Europäisches Patentamt

European Patent Office

Office européen des brevets

(11) **EP 1 074 088 B1**

(12) **EUROPÄISCHE PATENTSCHRIFT**

(45) Veröffentlichungstag und Bekanntmachung des Hinweises auf die Patenterteilung:
**31.10.2001  Patentblatt 2001/44**

(21) Anmeldenummer: **99912963.8**

(22) Anmeldetag: **14.04.1999**

(51) Int Cl.$^7$: **H03H 17/06**

(86) Internationale Anmeldenummer:
**PCT/AT99/00094**

(87) Internationale Veröffentlichungsnummer:
**WO 99/54997 (28.10.1999 Gazette 1999/43)**

(54) **VERFAHREN ZUR WANDLUNG DER ABTASTRATE**

METHOD FOR CONVERTING THE SAMPLING RATE

PROCEDE DE TRANSFORMATION DES VITESSES D'ECHANTILLONAGE

(84) Benannte Vertragsstaaten:
**DE FR GB**

(30) Priorität: **20.04.1998  AT  66498**

(43) Veröffentlichungstag der Anmeldung:
**07.02.2001  Patentblatt 2001/06**

(73) Patentinhaber: **Siemens AG Österreich**
**1210 Wien (AT)**

(72) Erfinder: **LENGER, Manfred**
**A-1010 Wien (AT)**

(74) Vertreter: **Matschnig, Franz, Dipl.-Ing.**
**Siebensterngasse 54**
**1070 Wien (AT)**

(56) Entgegenhaltungen:
**EP-A- 0 176 946**

- **AES 76th CONVENTION, 1984 OCTOBER 8-11 NEW YORK. R. LAGADEC u.a.: A NEW APPROACH TO SAMPLING RATE SYNCHRONIZATION. p1-12 XP002113883**

EP 1 074 088 B1

**Beschreibung**

Verfahren zur Wandlung der Abtastrate bei der Übergabe eines abgetasteten Signals von einem ersten System mit einer ersten Abtastrate auf ein zweites System mit einer zweiten Abtastrate.

Die Erfindung betrifft ein Verfahren zur Wandlung der Abtastrate bei der Übergabe eines abgetasteten Signals von einem ersten System mit einer ersten Abtastrate auf ein zweites System mit einer zweiten Abtastrate, bei welchem neue Abtastwerte aus den ursprünglichen Abtastwerten, beispielsweise durch Interpolation berechnet werden.

Falls zwei Systeme mit unterschiedlichen Abtastraten arbeiten, die entweder systembedingt grundlegend unterschiedlich oder aber aufgrund der Ungenauigkeiten der je verwendeten Taktgeber auch nur geringfügig verschieden sind, ist es erforderlich, eine Abtastratenwandlung vorzunehmen, es sei denn, man begnügt sich damit, Abtastwerte zu wiederholen bzw. Abtastwerte auszulassen. Das letztgenannte "primitive" Verfahren führt naturgemäß zu erheblichen Fehlern, die sich beispielsweise in Audiosignalen als Knacken bemerkbar machen.

Eine Abtastratenwandlung wie bis jetzt bekannt ist allerdings mit erheblichem Rechenaufwand verbunden, der zum Teil in der erforderlichen Bestimmung der Abtastzeitpunkte liegt. In diesem Zusammenhang sei auf die EP 0 387 507 B1 der Anmelderin sowie auf den dort behandelten Stand der Technik verwiesen.

Das Problem der unterschiedlichen Abtastraten tritt insbesondere auch beim Übergang eines digitalen Funktelefonnetzes auf ein digitales Festnetz auf. So beträgt beispielsweise der erlaubte Frequenzfehler bei einer GSM-Basisstation $\pm$ 0,05 ppm, innerhalb eines ISDN-Netzes liegt der tolerierte Frequenzfehler jedoch bei z.B. $\pm$ 50 ppm oder $\pm$ 100 ppm, sodaß sich eine maximale Frequenzdifferenz beider Systeme von $\pm$ 50,05 oder $\pm$ 100,05 ppm ergibt. Arbeitet beispielsweise das ISDN-Netz mit einer höheren Abtastfrequenz als das GSM-System, so werden in der Zeiteinheit seitens des ISDN-Systems mehr Abtastwerte erzeugt, als in dem GSM-Netz benötigt. Arbeitet etwa das ISDN-System mit einer Abtastfrequenz von 8 kHz + 100 ppm, entsprechend 8000,8 Hz und das zweite System mit einer Abtastfrequenz von genau 8 kHz, so erzeugt das erste System in 10 Sekunden 80008 Abtastwerte, obwohl das zweite System in diesem Zeitraum lediglich 80000 Abtastwerte benötigt. Die Differenz von 8 Abtastwerten muß daher ausgeglichen werden. Eine Möglichkeit für einen solchen Ausgleich ist bei DECT/ISDN-Schnittstellen bekannt geworden und dort vor allem hardwaremäßig implementiert.

Eine Aufgabe der Erfindung liegt darin, eine von der Hardware weitgehend unabhängige Lösung des obgenannten Problems zu finden, die sich keines rechenzeitintensiven Verfahrens bedient und daher in der Verwirklichung kostengünstig ist.

Diese Aufgabe wird mit einem Verfahren der eingangs genannten Art gelöst, bei welchem erfindungsgemäß von dem ersten System einlangende Abtastwerte über je konstante, durch die Abtastrate des zweiten Systems bestimmte Zeitabschnitte in einem Block von Abtastwerten gesammelt werden, daß überprüft wird, ob in jedem Zeitabschnitt eine Sollanzahl von Abtastwerten vorhanden ist, daß, sofern die festgestellte Anzahl unter oder über der Sollanzahl liegt, somit eine Taktabweichung zwischen beiden Systemen vorliegt, zumindest ein Abschnitt dieses Blockes mit p Abtastwerten durch einen neuen Abschnitt ersetzt wird, wobei dieser neue Abschnitt entsprechend der festgestellten Abweichung hinsichtlich der Anzahl der Abtastwerte korrigiert ist, und die neuen Abtastwerte innerhalb des Abschnittes aus den ursprünglichen Abtastwerten z.B. mit Hilfe von Polynomapproximationsverfahren berechnet werden.

Dank der Erfindung entfällt der sonst für die Bestimmung der Abtastzeitpunkte erforderliche Rechenaufwand, wobei man es durch die Wahl der Länge des Abschnittes des Blockes in der Hand hat, die Beeinflussung der Signalqualität in Grenzen zu halten.

Die Erfindung zeigt zufolge ihrer Kostengünstigkeit besondere Vorteile falls das erste bzw. das zweite System ein digitales Telefonnetz bzw. ein nach einem TDMA-Verfahren arbeitendes Mobilfunknetz ist.

Die Erfindung samt weiterer Vorteile ist im folgenden unter Zuhilfenahme der Zeichnung an Hand von Ausführungsbeispielen näher erläutert. In der Zeichnung zeigen

     Fig. 1 eine schematische Darstellung der für die Ausführung der Erfindung wesentlichen Blöcke und

     Fig.2 die Lage von Abtastzeitpunkten an einem Signalausschnitt.

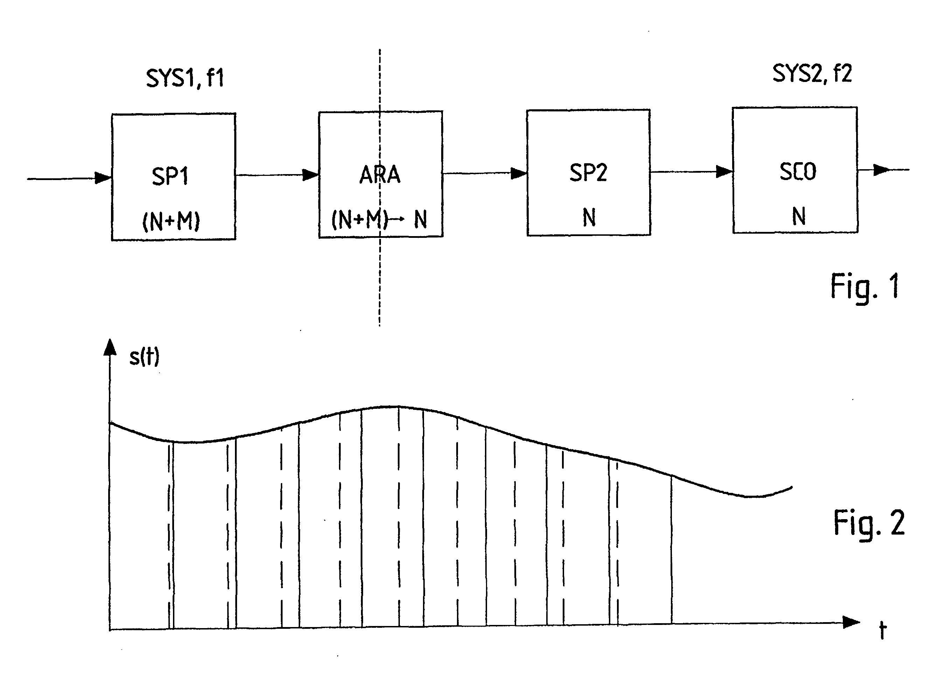

In Fig.1 ist, von links nach rechts, ein erster Sprachpuffer SP1, eine Abtastratenanpassung ARA, ein zweiter Sprachpuffer SP2 und ein Sprachcoder SCO dargestellt, wobei das zur linken Seite einer strichlierten symbolischen Trennungslinie liegende erste System SYS1 zum Beispiel mit einer geringfügig höheren Abtastrate arbeite als das zur rechten Seite der strichlierten Linie gezeigte zweite System SYS2, Bei dem ersten System kann es sich beispielsweise um ein ISDN-Netz handeln, bei dem zweiten System um ein GSM-System bzw. ein anderes digitales Mobilfunknetz. Nach bestimmten Zeitintervallen werden von dem ersten System SYS1 M Abtastwerte mehr geliefert als das zweite System SYS2 verarbeiten kann, nämlich N+M Abtastwerte. Bei einem GSM-System beträgt die Sollanzahl der Abtastwerte in einem Block N=160. Dies entspricht bei einer Abtastrate f2 = 8 kHz einem Zeitabschnitt von N/f2 = 20 ms. Die Erfindung sieht nun vor, daß aus n*N + M Abtastwerten des ersten Systems SYS 1 n*N Abtastwerte für das zweite System SYS2 errechnet werden, wobei mit n die Anzahl der verwendeten Blöcke bezeichnet ist. Dadurch läßt sich das Problem der mangelnden Synchronisation beheben.

Das erste System SYS1 liefert Abtastwerte mit der Abtastfrequenz f1 dieses Systems, der Sprachpuffer SP1 sammelt dabei Blöcke mit N+M Abtastwerten und diese werden in der Abtastratenanpassung ARA auf N Abtastwerte umgesetzt. Der zweite Sprachpuffer SP2 gibt dann diese N Abtastwerte an den Sprachcoder SCO weiter, welcher die Blöcke mit je N Abtastwerten verarbeitet. Das Verfahren wird in der Praxis natürlich in beiden Richtungen ablaufen, wobei die hier getrennt gezeichneten Sprachpuffer beispielsweise auch in einem RAM mit zyklisch umlaufendem Pointer verwirklichbar sind. Dem Fachmann stehen jedenfalls für die Realisierung der Erfindung geeignete Prozessoren, Speicher, etc. zur Verfügung. Arbeitet das erste System SYS1 mit einer niedrigeren Abtastfrequenz als das zweite System SYS2 so ist analog vorzugehen, d.h. es werden aus n*N-M Abtastwerten des ersten Systems n*N Abtastwerte für das zweite System SYS2 erzeugt.

Das auf diese Weise auszugleichende Frequenzverhältnis kann maximal betragen:

$$\Delta f \rightarrow \Delta_f = \pm\frac{n \cdot N + M}{n \cdot N} - 1$$

Geht man beispielsweise von einer Länge eines Sprachpuffers N=160 - wie im GSM-System üblich - aus, weiters von der Verwendung nur eines Sprachpuffers, d.h. n=1 und davon, daß seitens des ersten Systems SYS 1 ein Abtastwert zuviel vorliegt, d.h. M=1, so erhält man

$$\Delta f \rightarrow \Delta_f = \pm 0{,}625\% = \pm 6250 ppm \text{ (n=1, N=160, M=1)}$$

Die eingangs beispielsweise genannte Abweichung von ±50,05 bzw. ±100 ppm bzw. ±100,05ppm läßt sich somit mühelos ausgleichen.

Da eine exakte Bestimmung der Abtastzeitpunkte entfällt, werden die Abtastzeitpunkte angenähert. Man kann beispielsweise nur einen p Abtastwerte umfassenden Abschnitt eines Blockes (entsprechend einem Sprachpuffer) mit N Abtastwerten verwenden, um aus diesem Abschnitt p+1 neue Abtastwerte zu erzeugen. Wenn man davon ausgeht, daß der erste und der letzte Abtastwert auf denselben Abtastzeitpunkt fallen und dem ersten Zeitpunkt der Wert 0 zugewiesen wird, so errechnen sich die neuen Abtastzeitpunkte zu:

$$t_i = \frac{(p\text{-}1)\tau 2}{p} \cdot i,$$

wobei τ2 das Abtastintervall, entsprechend dem Kehrwert der Abtastrate f2 des zweiten Systems SYS 2, $t_i$ die neuen Abtastzeitpunkte und i den laufenden Index aus [1, (p-1)] bedeuten.

In Fig. 2 sind, für p=10, die p·Abtastzeitpunkte im ersten System SYS1 mit vollen Linien bezeichnet, die p+1 Abtastzeitpunkte des zweiten Systems SYS2 hingegen mit sirichlierten Linien.

Wenn sodann die neuen Abtastzeitpunkte festliegen, können die dazugehörigen Abtastwerte über bekannte Polynomapproximationsverfahren berechnet werden, wobei die Güte der Approximation einerseits von der Art des verwendeten Verfahrens und andererseits von der Anzahl der verwendeten, alten Abtastwerte abhängt. Die Qualität eines Sprachsignales oder eines anderen Signales hängt daher von dem Faktor p ab. Wird p klein gewählt, so müssen nur wenige neue Abtastwerte berechnet werden, und der Rechenaufwand bleibt gering. Durch den Übergang auf eine quasi neue Abtastfrequenz $f_{neu}=[(p+1)/p]\cdot f2$ für die neuen Abtastwerte, und durch die Ausgabe der Abtastwerte mit der Abtastfrequenz f2 des zweiten Systems SYS 2, wird bei kleinen p der Effekt z.B. als Knacks hörbar sein. Wird p größer gewählt, steigt auch der Rechenaufwand, er ist jedoch immer noch geringer als bei bekannten Abtastratenumwandlern, der Sprung von der alten zu der neuen Abtastfrequenz wird immer kleiner, und schließlich wird der "Knacks"-Effekt unhörbar.

Aus dem obigen geht weiters hervor, daß die Abtastfrequenz f1 des ersten Systems SYS 1 dadurch angepaßt wird, daß nicht in jedem Sprachpuffer eine Erhöhung oder Verringerung der Anzahl der Abtastwerte erfolgt, sondern lediglich dann, wenn dies durch unterschiedliche Abtastfrequenzen erforderlich wird. Unter TDMA-Verfahren sollen auch FDMA/TDMA-Verfahren verstanden werden, wie sie z.B. bei GSM Mobilfunk Verwendung finden, doch ist die Erfindung auch nicht auf TDMA-Verfahren beschränkt.

**Patentansprüche**

1. Verfahren zur Wandlung der Abtastrate bei der Übergabe eines abgetasteten Signals von einem ersten System (SYS 1) mit einer ersten Abtastrate (f1) auf ein zweites System (SYS 2) mit einer zweiten Abtastrate (f2), bei welchem neue Abtastwerte aus den ursprünglichen, in Blöcken vorliegenden Abtastwerten, beispielsweise durch Interpolation berechnet werden,
   **dadurch gekennzeichnet, daß**

   von dem ersten System (SYS 1) einlangende Abtastwerte über je konstante, durch die Abtastrate (f2) des zweiten Systems (SYS 2) bestimmte Zeitabschnitte (N/f2) in einem Block von Abtatwerten gesammelt werden,

   daß überprüft wird, ob in jedem Zeitabschnitt eine Sollanzahl (N) von Abtastwerten vorhanden ist,

daß, sofern die festgestellte Anzahl unter oder über der Sollanzahl liegt, somit eine Taktabweichung zwischen beiden Systemen vorliegt, zumindest ein Abschnitt dieses Blockes mit p Abtastwerten durch einen neuen Abschnitt ersetzt wird, wobei dieser neue Abschnitt entsprechend der festgestellten Abweichung hinsichtlich der Anzahl der Abtastwerte korrigiert ist,

und die neuen Abtastwerte innerhalb des Abschnittes aus den ursprünglichen Abtastwerten z.B. mit Hilfe von Polynomapproximationsverfahren berechnet werden.

**2.** Verfahren nach Anspruch 1, **dadurch gekennzeichnet, daß** die Berechnung der neuen Abtastwerte anhand der Abtastwerte von n Blöcken erfolgt.

**3.** Verfahren nach Anspruch 1 oder 2, **dadurch gekennzeichnet, daß** das erste bzw. das zweite System ein digitales Telefonnetz bzw. ein nach einem TDMA-Verfahren arbeitendes Mobilfunknetz ist.

## Claims

**1.** Process for converting the sampling frequency in the passing of a sampled signal from a first system (SYS1) with a first sampling frequency (f1) to a second system (SYS2) with a second sampling frequency (f2), wherein new sampling values are calculated from the original sampling values provided in blocks, for example by interpolation, **characterised in that**

sampling values arriving from the first system (SYS1) are collected in a block of sampling values over time intervals (N/f2) which are each constant and determined by the sampling frequency (f2) of the second system (SYS2), that a check is made to see whether in each time interval a desired number (N) of sampling values is present, that, provided the number established lies below or above the desired number and there is therefore a timing discrepancy between the two systems, at least a portion of this block with p sampling values is replaced by a new portion, wherein this new portion is corrected corresponding to the established discrepancy with respect to the number of sampling values, and the new sampling values are calculated within the portion from the original sampling values, for example with the aid of polynomial approximation processes.

**2.** Process according to claim 1, **characterised in that** the calculation of the new sampling values is achieved with the aid of the sampling values of n blocks.

**3.** Process according to claim 1 or 2, **characterised in that** the first or the second system is a digital telephone network or a mobile telephone network operating according to a TDMA process.

## Revendications

**1.** Procédé pour convertir la cadence d'échantillonnage lors du transfert d'un signal échantillonné depuis un premier système (SYS 1) comportant une première cadence d'échantillonnage (f1) à un second système (SYS 2) comportant une seconde cadence d'échantillonnage (f2), selon lequel de nouvelles valeurs d'échantillonnage sont calculées à partir des valeurs d'échantillonnage initiales, présentes sous la forme de blocs, par exemple par interpolation, **caractérisé en ce que**

les valeurs d'échantillonnages arrivant du premier système (SYS 1) sont rassemblées en un bloc de valeurs d'échantillonnage pendant des créneaux temporels respectivement constants (N/f2) déterminés par la cadence d'échantillonnage (f2) du second système (SYS 2), qu'un contrôle est effectué pour savoir s'il existe, dans chaque créneau temporel, un nombre de consigne (N) de valeurs d'échantillonnage, que, dans la mesure où le nombre fixé est inférieur ou supérieur au nombre de consigne, il existe par conséquent un écart de cadence entre les deux systèmes, au moins une section de ce bloc comportant p valeurs d'échantillonnage est remplacée par une nouvelle section, cette nouvelle section étant corrigée en fonction de l'écart fixé, en ce qui concerne le nombre des valeurs d'échantillonnage, et les nouvelles valeurs d'échantillonnage à l'intérieur de la section sont calculées à partir des valeurs d'échantillonnage initiales par exemple à l'aide de procédés d'approximation polynomiale.

**2.** Procédé selon la revendication 2, **caractérisé en ce que** le calcul des nouvelles valeurs d'échantillonnage s'effectue sur les valeurs d'échantillonnage de n blocs.

**3.** Procédé selon la revendication 1 ou 2, **caractérisé en ce que** le premier ou le second système est un réseau téléphonique numérique ou un réseau radio mobile travaillant selon le procédé TDMA.

EP 1 074 088 B1

SYS1, f1

| SP1 (N+M) | ARA (N+M)→ N | SP2 N | SCO N |

SYS2, f2

Fig. 1

$s(t)$

$t$

Fig. 2